# EUROPEAN PATENT APPLICATION

(11) **EP 0 946 086 A1**
(43) Date of publication of application: **29.09.1999**
(21) Application number: 98830167.7
(22) Date of filing: 23.03.1998
(51) Int. Cl.: H05K 13/00, H01L 21/00

(54) **Plated leadframes with cantilever leads**

(71) Applicant: STMicroelectronics S.r.l., 20041 Agrate Brianza MI (IT)
(72) Inventor: Cigada, Andrea Giovanni, 20155 Milano (IT); Tondelli, Fulvio Silvio, 20146 Milano (IT)
(74) Representative: Pellegri, Alberto

(57) **Abstract**

According to the present invention, a metal frame as patterned by die stamping, has the outermost end portion of each patterned pin extending freely, without constraints, from a line of metal bridge connections (dam bar), and the end face of each pin is also covered as any other surface of the frame by a coating layer or multilayer of metals different from the metal of the die stamped frame. The coating layer or multilayer contains at least on its outer surface, a noble metal such as palladium or gold. The tip of the pins is not subject to any cutting and/or trimming after plating the die stamped frame, not even during separation of the patterned frame from the surrounding metal at the end of the encapsulation process, when the pins are eventually bent into shape.

## Description

### FIELD OF THE INVENTION

The present technique relates to fabrication techniques of integrated devices and in particular to an assembling frame for surface mount integrated device whose pins or leads are eventually soldered with a Pb/Sn alloy onto respective mounting pads defined on a printed circuit board.

### BRIEF DESCRIPTION OF THE DRAWINGS

The pre-coating of the leads or pins of a metal frame, commonly of die stamped copper or Fe/Ni alloy, for soldering them on the printed circuit board with an eutectic Sn/Pb alloy is a time consuming technique especially with increasingly small sizes and exasperated densities of the pins.

In this context, a decisive step forward has been the recent development of alternative techniques based on the use of assembling die stamped metal frames pre-coated with a layer or a multilayer of metals or alloys exhibiting a high compatibility with silicon dice assembling operations, with the welding of the connecting wires as well as with the eventual soldering of the tips of the pins of the device on respective metal pads, defined on the printed circuit board, by way of a conventional soldering technique with an eutectic Sn/Pb alloy.

It is more and more frequent the use of die stamped frames of copper or of any other adequate metal, pre-coated with a nickel and/or a nickel-palladium and/or a gold film. These coatings whose thickness may range between 1 and 2 µm are very effective under many aspects and in particular promote an adequate wettability of the coated pin surfaces by the molten eutectic Sn/Pb alloy used in assembling the devices on the printed circuit board.

The manufacturer of integrated devices has the opportunity of eliminating from his fabrication process the steps of pre-coating with eutectic alloy the pins, or any other plating treatment of the metal frames, which may be purchased from specialized suppliers already pre-coated with the above noted metal films chemically or galvanically deposited onto the whole die-stamped frame.

On the other hand, the conventional die stamping of a copper strip produces a modular patterning of several frames in special stamping molds, whereby the various functional features or portions of each frame remain connected to each other and to the surrounding metal, or to a second line of connecting metal bridges referred to as "connection bar", from which they will be separated during the conclusive steps of the fabrication process of the IC devices.

Only after completing the encapsulation of the device, the single pins are separated from the surrounding metal or from the "connection bar" and also the ones from the others by cutting the metal bridge connections along the so-called perimetral dam bar line, upon which abut the edges of the mold used for encapsulating with resin the IC device during the assembling process, and by a perimetral trimming done internally of the outermost perimeter of the die stamped area of each frame during the patterning thereof, before or after bending the pins.

The array of adjacent pins are in fact separated, trimmed and bent into shape into dedicated molds or by the use of special bending devices, interpin cutters and tip trimming devices, that impart to the pins a precise shape as needed to superficially mount them on a printed circuit board.

Figures 1a and 1b show metal frames defined by die stamping a copper strip as well as details of the patterning of the pins, by indicating with a broken line the perimeter of the cut done after encapsulation and with dash and dot lines the cuttings that are done to break the metal bridge connections along the so-called "dam bar".

Figures 2a, 2b and 2c illustrate forming operations of the pins carried out by rolling, as well as the final cutting and trimming of the tips of pins.

Figures 3a and 3b show an alternative technique of forming and trimming the pins by using cam mechanisms.

As it may be noticed, the shaping, cutting and trimming techniques of the pins of the encapsulated device always involve a cutting of the outer end or tip of the pins.

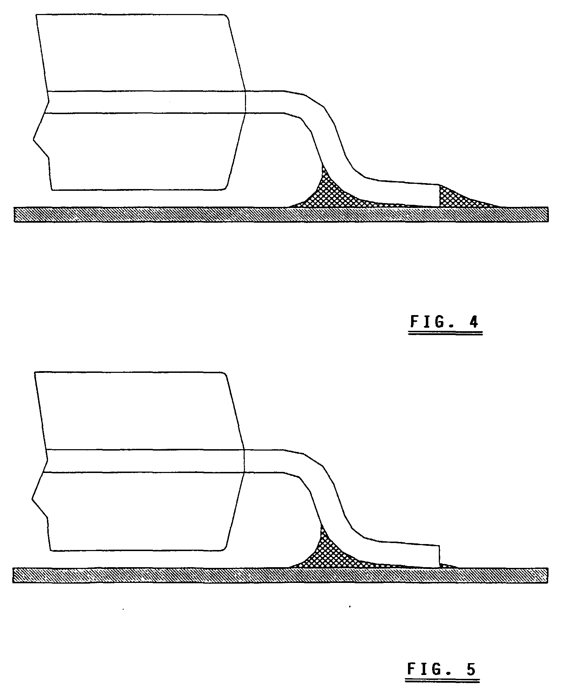

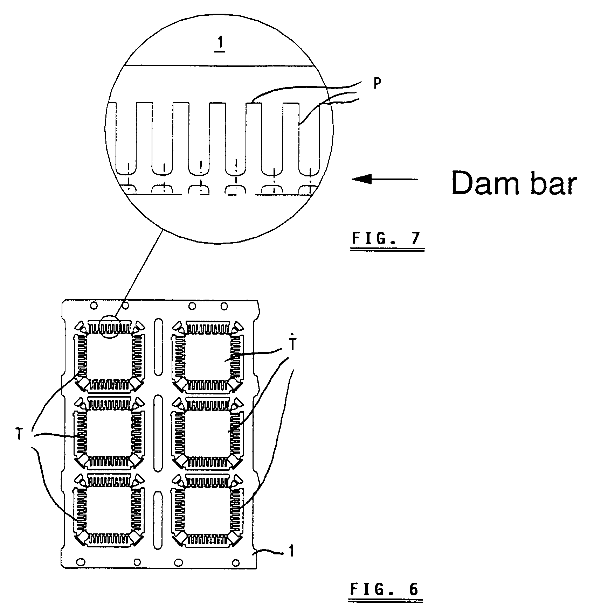

While in case of conventionally pre-tinned pins, as shown in Fig. 4, the soldering to the pad of the printed circuit normally has an optimal web configuration, in the case of thin film precoated metal frames, for example with a nickel-palladium alloy or with gold, the soldering takes a more critical configuration, as depicted in Fig. 5.

For the case of frames plated with thin metal films, typically of nickel, nickel-palladium, gold and similar metals or alloys, especially of the most external or top coating film which is usually of or contains a noble metal such as palladium or gold, alloyed or not to other metals, is extremely thin and the wettability of the cut end surface of the pins by the molten eutectic Sn/Pb alloy during the soldering of the surface mount devices on the printed circuit board, is often inadequate to reliably establish a good electrical and mechanical connection of the pin to the respective metal pad.

The reasons for such a different performance of pre-tinned frames from that of pre-plated frames with a noble metal-containing thin top coating, even though both are subjected to trimming, are not clear.

It is supposed that when trimming a copper frame pre-coated with a rather thick layer of tin, the cut end surface of the pins remains sufficiently wettable by the eutectic Sn/Pb alloy during the soldering phase of the devices onto the board, by virtue of a significant "smearing" of the tin over the cut surface by the cutting blade.

By contrast, it may be hypothesized that in the case of a pre-coating of the frames with nickel-palladium, gold, and similar metal films containing a noble metal, of a thickness infinitesimally smaller than that of the tin layer of a tinned frame, no significant transfer of noble metal on the cut face of the pins occur, and therefore the wettability of the "bare" copper of the trimmed end of the pins is grossly inadequate to ensure an optimal shape of the web of solder.

### SUMMARY OF THE INVENTION

It has now been found and is the object of the present invention, a frame of copper or of other metal or alloy, pre-coated with thin metal films, the outermost of which contains a noble metal that has a pattern configuration that overcomes the above mentioned wettabiliy problems by the molten eutectic tin/lead alloy which is normally pre-deposited onto the printed circuit board. Moreover the novel frame of the invention simplifies the finishing steps of the fabrication process of the devices while reducing the metal discards or improving usage of the starting sheet metal strips on which the frames are patterned by stamping.

According to the present invention, a metal frame as patterned by die stamping, has the outermost end portion of each patterned pin extending freely, without constraints, from a line of metal bridge connections (dam bar), and the end face of each pin is also covered as any other surface of the frame by a coating layer or multilayer of metals different from the metal of the die stamped frame. The coating layer or multilayer contains at least on its outer surface, a noble metal such as palladium or gold. The tip of the pins is not subject to any cutting and/or trimming after plating the die stamped frame, not even during separation of the patterned frame from the surrounding metal at the end of the encapsulation process, when the pins are eventually bent into shape.

The end surface of each pin of the finished IC device is covered by the deposited coating containing noble metal as any other part of the metal frame and thus remains perfectly wettable by the molten eutectic Sn/Pb alloy when the devices are soldered on a printed circuit board.

An optimal mechanical and electrical connection of each pin to the respective pad of the printed circuit is assured with a high reliability.

### BRIEF DESCRIPTION OF THE DRAWINGS

The various aspects and advantages of the invention will become even more evident through the following description of an embodiment and by comparing it with frames made according to the known technique, while referring to the attached drawings, wherein:

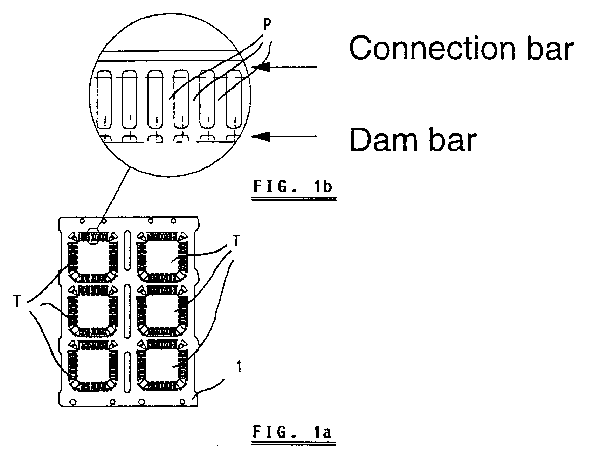

**Figures 1a** and **1b** show frames patterned by die stamping and enlargements of the outermost portion of the pins;

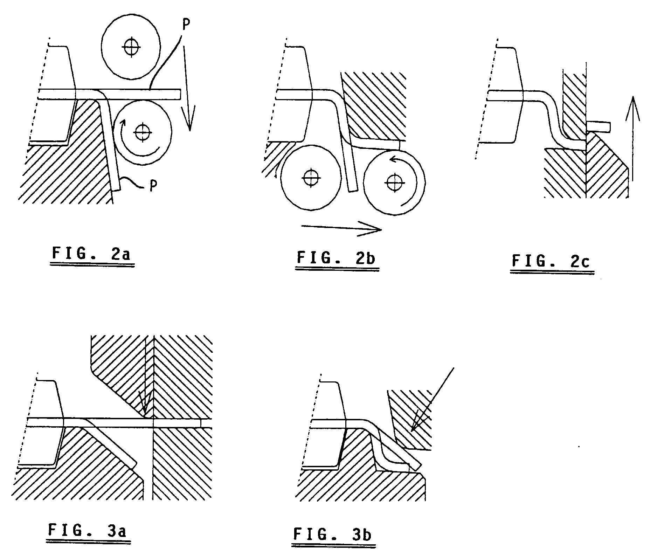

**Figures 2a**, **2b**, **2c**, **3a** and **3b** illustrate common cutting, forming and end trimming processes of pins;
**Figures 4** an**d 5** offer a comparison between an efficient solder web configuration and a less efficient or critical solder web configuration;

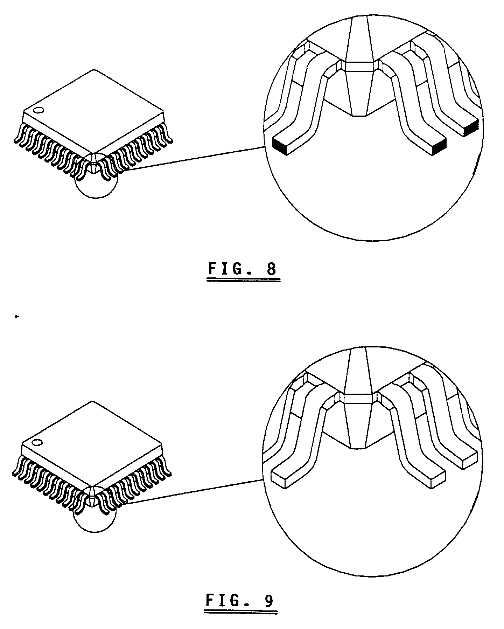

**Figures 6** and **7** are plan views of die stamped frames made according to the present invention;
**Figures 8** and **9** offer a comparison between pins of a surface mount device using prior art frames and frames made according to the present invention;

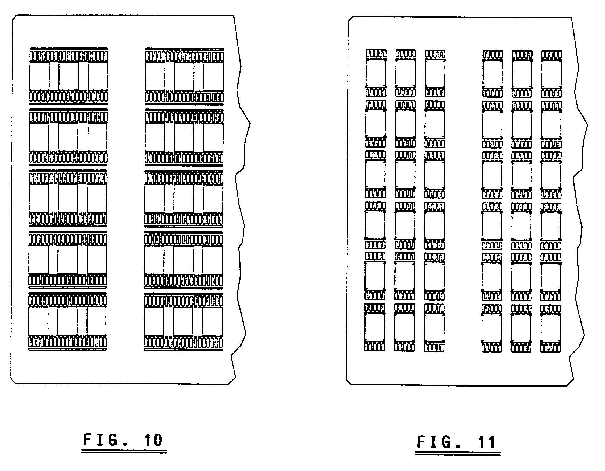

**Figures 10** and **11** are plan views of patterned frames made according to the prior art and according to the present invention.

### DESCRIPTION OF AN EMBODIMENT OF THE INVENTION

As already mentioned above, a common patterning configuration of metal frames for surface mount devices is shown in Figures 1a and 1b. The plan view of Fig. 1a depicts six frames T, defined by die stamping a strip of copper or alloy plate, for example of an alloy of Fe and Ni. The enlarged partial view of Fig. 1b shows in more details the profile of the pins P, that is the outermost portion of them, starting from a continuous line (dam bar) of metal bridge connections to a continuous line (usually referred to as connection bar) of outermost metal bridge connections.

The dot and dash lines indicate the lines of cuttings that are performed required to electrically separate one pin from the adjacent ones, while the broken line indicates the line of the perimetral cutting that is made at the end of the assembling steps to separate the various devices.

Figures 2a, 2b and 2c show the steps of the bending by rolling of the pins P, and Fig. 2c shows the cutting of the ends of the pins as a final separation-trimming step.

Figures 3a and 3b illustrate an alternative technique in which the pins are cut before being bent to shape.

Fig. 4 depicts pictorially a solder web cross section of an optimal soldering of a pin onto a respective pad of the printed circuit board, as normally obtained with pre-tinned frames.

Fig. 5 depicts pictorially a solder web cross section of an unsatisfactory soldering of a pin onto a respective pad of the printed circuit board as it is often observed with frames pre-coated with a thin film of nickel and a palladium-nickel alloy or palladium or gold top coating, according to a known technique.

Fig. 6 is plan view of six frames T patterned according to the present invention and Fig. 7 is an enlarged detail view of the patterned pins P. In the enlarged view of Fig. 7, differently from known frames, the pins P are defined with their outermost portion that extends from the line of metal bridge connections referred to as the dam bar, without any constraints, their ends being separated from the surrounding metal of the matrix plate 1, commonly of copper, after die stamping the frames.

The dot and dash lines indicate the lines of cutting to be executed after completing encapsulation in order to separate electrically the pins from one another. Differently from the prior techniques, no trimming of the ends of the pins occurs.

The stamped metal frames are then coated with one or preferably more superimposed thin films of selected metals by chemical and/or electrochemical metal deposition techniques over all their surfaces. Therefore also the end surfaces of the cantilever outermost portion of the pins P of the stamped frames are coated like any other surface, typically with nickel and with a nickel-palladium or a palladium top coating having a thickness that may generally be between 0,03-0,08 µm.

Of course, before depositing such a final top coating containing palladium or another noble metal, such as gold, that prevents the formation of insulating native oxide films, one or more adhesion layers containing or not a certain amount of noble metal may be deposited on the frame metal base to build a compatible and adherent solder-wettable coating, capable of promoting a most effective soldering with eutectic tin/lead alloy of the device onto the printed circuit board.

Commonly, such multilayers may be composed of nickel and/or nickel-palladium films, deposited in succession, using different techniques, such as for example a chemical deposition to prime the surface to receive a further coating of nickel by galvanic plating, on top of which a thin layer of noble metal is thereafter galvanically deposited.

Of course, the deposition techniques and the number and composition of the different metal layers deposited on the die stamped base metal of the patterned frame may be different and do not affect the overall scope of the present invention which rests on the uncustomary patterning configuration of the die stamped frames, avoiding any trimming operations after coating of the patterned frame with the metal film, which has been found instrumental in preventing poor soldering during the successive mounting of the devices onto printed circuit boards.

The frames realized according to the invention provide for an uninterrupted coating even on the end surface of the pins, as pictorially depicted in Fig. 9, differently from prior art frames, the pins of which are cut before or after bending them as pictorially depicted in Fig. 8 by way of comparison.

The peculiar frame pattern and in particular the patterning of the outermost portion of the pins of the present invention, provide further advantages in terms of a better utilization of the metal strip.

In practice, given a certain standardized metal strip length as normally handled by the die stamping machines, the frame pattern of the present invention permits a better utilization of the base strip, as may be appreciated by comparing Figures 10 and 11, wherein for identical lengths of the metal strip, the geometry of the frames of the invention (Fig. 11) permits to produce a greater number of frames per unit length if than in the case of a traditional geometry of patterned frames (Fig. 10).

## Claims

1. A metal frame for assembling integrated devices for surface mounting on a printed circuit card constituted of a metal plate patterned by die stamping a metal strip and coated after stamping with one or more metal and/or metal alloy layers, at least the top coating layer of which contains a noble metal, the stamping patterning several frames along said strip, each having an array of pins, the outermost portion of which extends from a line (dam bar) of metal bridge connections upon which abuts the edges of encapsulation mold during the assembling of the integrated device,
characterized in that
said outer portion of each of said patterned pins extends freely in a cantilever fashion from said line of metal bridge connections (dam bar);
said coating metal layer or layers covering also the end surface of each pin.

2. The frame according to claim 1, characterized in that said metal strip is of copper and said coating films comprise at least a layer of galvanically deposited nickel and a galvanically deposited top coating layer containing a noble metal.
